# EUROPEAN PATENT SPECIFICATION

(11) **EP 4 498 098 B1**
(45) Date of publication and mention of the grant of the patent: **11.11.2026**
(21) Application number: 23188241.6
(22) Date of filing: 27.07.2023
(51) Int. Cl.: G01R 19/00, G01R 31/42, H02M 1/00, H02M 7/5387

(54) **AC CURRENT ACQUISITION METHOD**
WECHSELSTROMERFASSUNGSVERFAHREN
PROCÉDÉ D'ACQUISITION DE COURANT ALTERNATIF

(43) Date of publication of application: 29.01.2025
(73) Proprietor: Valeo Electrification, 95892 Cergy Pontoise (FR)
(72) Inventor: ELDALEEL, Mohamed, Cairo (EG); SEILMEIER,, Markus, Erlangen (DE)
(74) Representative: Valeo Powertrain Systems

(56) References cited:
- EP-A1- 3 654 524
- US-A1- 2011 080 125
- US-A1- 2018 309 399

## Description

The present invention relates to the fields of electronics and electrical engineering, and more particularly to the field of inverters and monitoring of such inverters.

Inverters are power electronic devices capable of generating alternating current (AC) from direct current (DC). Inverters can be integrated into motor vehicles, in particular hybrid or electric vehicles, to convert direct current supplied by batteries into alternating current to power an electric machine of the motor vehicle. The electric machine is then used to provide torque to the wheels of the motor vehicle.

To convert high voltage direct current supplied by the batteries into alternating current, the inverter can be controlled indirectly thanks to pulse width modulation (PWM) techniques.

The inverter is for instance operated with a six-step operation, which particularly works when the electric machine is operated in a field-weakening area, i.e. at the AC voltage boundary. In such six-step operation, a fundamental period is defined. This fundamental period is divided into subperiods or PWM periods, during which every power switch of the inverter is switched on and off only once in order to reduce switching losses in the inverter and to achieve the maximum possible fundamental frequency AC output voltage amplitude.

In other words, during the six-step operation only one switching bridge of the inverter, here a three-phase inverter, is operated for every subperiod using PWM signals. Such operation leads to an AC voltage coming out of the three phases of the inverter. As the AC voltage has a fundamental frequency of f₀, the frequency of the PWM signals or f_{PWM} is equal to 6*f₀.

The amplitude and phase of the fundamental frequency component of the alternating current, i.e. the input current for the electric machine, is a decisive part for accurate control of the torque at the shaft of the electric machine and finally at the wheels of the electric machine. Such a control implies a sampling of the current of the electric motor, at predetermined times of the PWM period, with the target to obtain the fundamental frequency component of the AC currents. In particular, current ripple due to the Pulse Width Modulated (PWM) AC output voltage and higher harmonics w.r.t. to fundamental frequency component shall be suppressed/decoupled.

It is known to divide the fundamental period into six subperiods, with one current value being sampled for each subperiod (i.e. each PWM period), such current value being then transformed into a rotating reference frame to obtain a direct current value which allows the monitoring of the inverter. Prior art document US 2011/080125 discloses such a three-phase motor driver comprising an inverter. The driver is operable in several modes, including pwm modes used at lower speeds and a synchronous mode used at high speeds, in which the rotational period is divided into six equally sized sectors, and wherein only one of the three inverter legs is switched at each transition from a sector to the next.

However, in the case of a six-step operation, unwanted (6n-1) and (6n+1) harmonics w.r.t. to the real measured phase currents appear. Such harmonics appear as 6n harmonics in coordinate systems which rotate with the fundamental frequency. As only one value per PWM period is transformed into the rotating coordinate system, effectively only 6 values per fundamental period exist, i.e. the sampling frequency is 6*f₀. According to the Nyquist criterion proper reconstruction of frequencies above half the sampling frequency, i.e. 3*f₀ is not possible. In particular, the Aliasing effect can appear which may provide an improper reconstruction of the fundamental frequency components via known acquisition methods with, as an example, 6n-1 harmonics and 6n+1 harmonics aliasing to the fundamental frequency. This leads to alternating current estimation inaccuracies and therefore to torque estimation inaccuracies.

The present invention fits into this context by providing a current acquisition method which eliminates unwanted harmonics by increasing the number of samples per subperiod which are transformed to the rotating coordinate system and which are averaged in the rotating coordinate system to suppress the disturbing higher harmonics.

In this context, the present invention is directed to a method of alternating current (AC) acquisition for an electric or hybrid vehicle electric machine, the method comprising:
- a step in which an inverter for the electric machine is operated according to a six-step operation, during which at least one fundamental period of 2π is used, the fundamental period being divided into six equal time periods, a maximum of one single switching action occurring during each equal time period;
- a step in which a plurality of values of an AC current of the inverter from a first reference frame are sampled for each equal time period;
- a step in which the sampled values are rotated from the first reference frame to a second reference frame;
- a step in which for each equal time period, the values of the plurality of values from the second reference frame are averaged;
- a step in which a current value is estimated according to the averaged sampled values.

The implementation of said method starts with a six-step operation of an inverter of the electric machine, which converts DC into AC. During the six-step operation, one fundamental period is divided into six equal time periods also called PWM periods. In other words, each time period corresponds to a sixth of the fundamental period. The six equal time periods, also called subperiods, are intervals which in steady state conditions are of an identical length timewise. As an example, with a fundamental period of 2π, each time period is of π/3.

A switching action of the inverter corresponds to an open switch of a given phase of the inverter being closed, i.e. switching from "on" to "off", and to a closed switch of the same phase being opened, i.e. switching from "off" to "on". As there is only one switching action per time period, there is a maximum of six switching actions during a given fundamental period.

After the six-step operation, there is a step in which values of an AC of the inverter, i.e the input current of the electric motor, are sampled; more precisely, at least two values are sampled for each time period. As such, there are at least twelve sampled values per fundamental period. These values are sampled from a first reference frame. Each sample value of the first reference frame is subsequently transformed into a second reference frame, which is a rotating reference frame.

Once in the second reference frame, the values sampled from a same time period are averaged; in other words, an average filter is applied to the samples of each time period. A DC current value, which corresponds to frequency components, can then be inferred from the averaged sample values.

The steps of the method of AC acquisition occur in this order; in particular, the rotation of the values from the first reference frame to the second reference frame takes place before the averaging step.

As there are at least two sample values for each time period, the number of samples is increased compared to prior art methods, which allows for a more precise reconstruction of the frequency components. More particularly, the averaging filter suppresses at least part, ideally most or all unwanted harmonics which are interferences or irrelevant results within the signal. The more samples, the more accurate the estimation of the frequency components will be.

According to an optional characteristic of the invention, the values are sampled at equidistant intervals.

In other words, the values are sampled at a same place for each time period. The sampling can for instance occur both in the middle and at the end of a given time period. Fast oversampling around the middle and/or end of the PWM period beneficially improves the signal quality. The difference between two values within the same period is equal to half of the period in which these two values are acquired.

According to an optional characteristic of the invention, the plurality of values for each equal time period corresponds to two values.

This corresponds to a first embodiment of the invention, in which two values are sampled for a single time period; as a result, there are twelve samples per fundamental period.

According to an optional characteristic, the two values are sampled respectively in a first π/6 interval of the equal time period and in a second π/6 interval of the equal time period.

This ensures that in the first embodiment and using equidistant sampling, the two values are sampled at equidistant intervals, as the 2π fundamental period being divided into twelve identical parts results in π/6 intervals.

According to an optional characteristic of the invention, the plurality of values for each equal time period corresponds to four values.

This corresponds to a second embodiment of the invention, in which four values are sampled for a single time period; as a result, there are twenty-four samples per fundamental period. As number of values sampled for each time period is increased, the number of suppressed unwanted harmonics is also increased; as such, more unwanted harmonics are suppressed when there are four samples for a given time period than when there are two, as is the case in the first embodiment.

According to an optional characteristic of the invention, the four values are sampled respectively in a first π/12 interval of the equal time period, a second π/12 of the equal time period, a third π/12 of the equal time period, and a fourth π/12 of the equal time period.

Such π/12 interval is the result of dividing the fundamental period of 2π four times for each π/3 equal time period.

Other embodiments of the invention can be obtained by selecting any integer number of samples per PWM period which is superior to 2, i.e. 3, 4, 5, 6...

According to an optional characteristic of the invention, one value of the plurality of values is sampled at the time at which the switching action occurs.

This corresponds to the aforementioned sampling at the end of a given time period, when the switches of a given phase of the inverter switch from "on" to "off" and from "off" to "on".

According to an optional characteristic of the invention, the rotation of the sampled values from the first reference frame to the second reference frame depends on an angle of the electric machine.

The passage from the first reference frame to the second reference frame, or rotating coordinate system, is obtained with a transformation angle which is consistent with the point in time when the sampling was conducted. In some cases, the second reference frame is aligned with a flux of a rotor of the electric machine; in other words, the rotating coordinate system can be rotor flux oriented. In other cases, the second reference frame is not aligned with such flux as long as it rotates with the fundamental angular frequency.

The electric machine angle is obtained by any angle sensing technology, resolver, tunneling magnetoresistive (TMR) device, encoder, sensorless control or other similar techniques.

According to an optional characteristic of the invention, a Park transformation is used to rotate the sampled values from the first reference frame to the second reference frame.

In other words, the Park transformation results in a reference frame change.

According to an optional characteristic of the invention, the sampling within the first reference frame is carried out using a sensing method.

The sensing method can be chosen between a 2-phase current sensor method, a 3-phase current sensor method, a single shot method or any other current sensing equivalent technique.

Other characteristics, details and advantages of the invention will become clearer on reading the following description, on the one hand, and several examples of realisation given as an indication and without limitation with reference to the schematic drawings annexed, on the other hand, on which:
[Fig. 1] is a flowchart of different steps forming an alternating current acquisition method according to the invention;
[Fig. 2] is a graph representing the output voltage of a single phase of a six-step operated three-phase inverter;
[Fig. 3] is a schematic representation of a sampling step of the AC acquisition method of Figure 1.

The characteristics, variants and different modes of realization of the invention may be associated with each other in various combinations, in so far as they are not incompatible or exclusive with each other. In particular, variants of the invention comprising only a selection of features subsequently described in from the other features described may be imagined, if this selection of features is enough to confer a technical advantage and/or to differentiate the invention from prior art.

Like numbers refer to like elements throughout drawings.

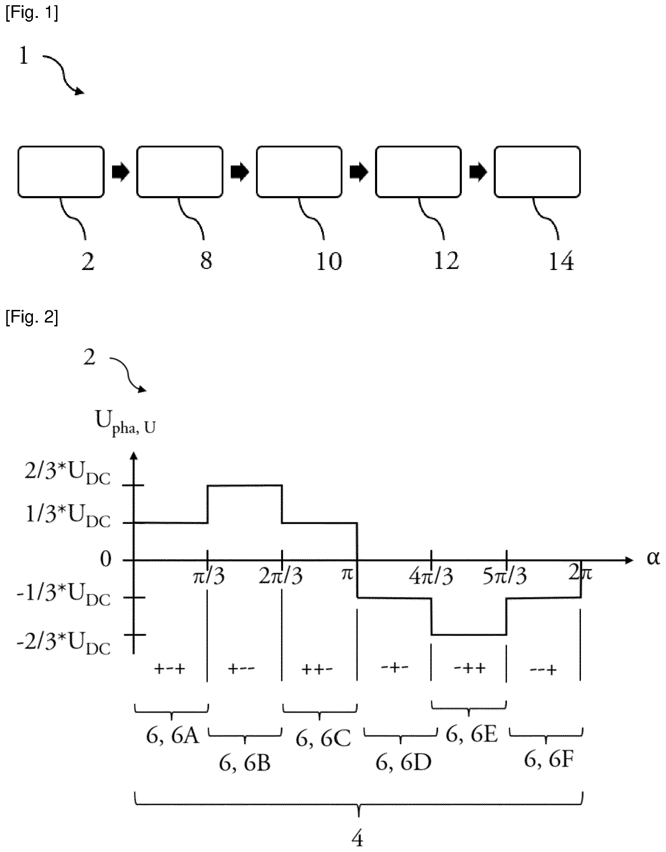

Figure 1 is a flowchart of a number of successive steps forming an alternating current (AC) acquisition method 1 according to the invention. Such AC acquisition method 1 is used in electric or hybrid vehicles which are equipped with an electric machine, for instance an electric motor. The electric machine is powered by alternating current which is generated by an inverter of the electric or hybrid vehicle from direct current supplied by batteries of said vehicle. The inverter is here a three-phase inverter.

One of the functions of the electric machine is to provide torque to the wheels of the electric or hybrid vehicle, the amount of torque which is transmitted to the wheels being controlled by controlling an input current sent to the electric machine. The AC acquisition method 1 according to the invention is a way to monitor the inverter from alternate current values retrieved from this inverter.

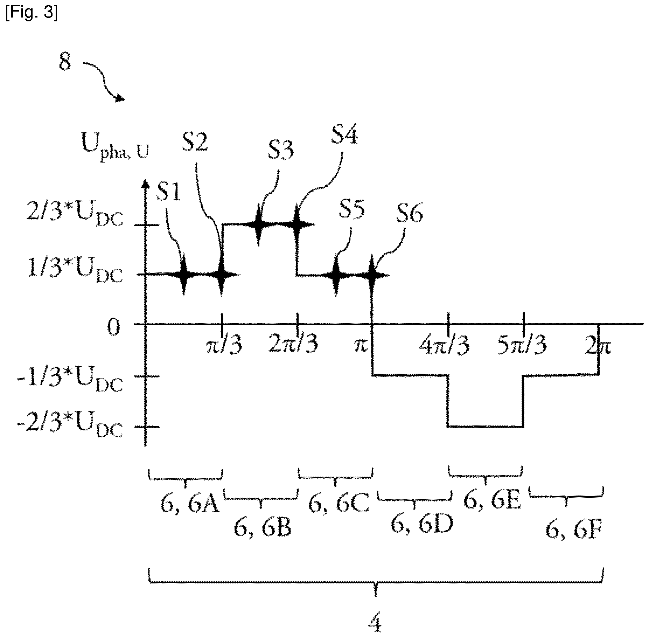

The AC acquisition method 1 will now be described in reference to the flowchart of Figure 1 and to the graphs of Figures 2 and 3. The AC acquisition method 1 of the invention occurs during a six-step operation step 2 of the inverter, which is particularly represented on Figure 2.

During the six-step operation step 2, a voltage U_{pha,U} of the first phase of the three-phase inverter is monitored during a fundamental period 4 which corresponds to 2rr. The fundamental period 4 is divided into subperiods or time periods 6; more precisely, the fundamental period 4 is divided into six time periods 6 of equal lengths, here six time periods 6 of π/3. The inverter carries out a maximum of six switching actions during the fundamental period 4, which equates to only one switching action during the course of each time period 6. As such, a closed switch of a given phase of the inverter goes from being "on" to being opened or "off", and an opened switch of said phase goes from being "off" to closed or "on" just once per time period 6. We note + the state of a phase where the top switch of said phase is operated to be "on", and the bottom switch to be "off", and - the state where the top switch of said phase is operated to be "off" and the bottom switch to be "on". As is visible on the graph of Figure 2, as a result of the switching actions in a first time period 6A occurring from 0 to π/3 each phase of the three-phase inverter is respectively +-+. More precisely, in this first time period 6A the top switch of the first phase is operated to be closed and the bottom switch of this first phase is operated to be opened so that the first phase is in a + state; the top switch of the second phase is operated to be opened and the bottom switch of this second phase is operated to be closed so that the second phase is in a - state; and the top switch of the third phase is operated to be closed and the bottom switch of this first phase is operated to be opened so that the third phase is in a + state. As a result, for the first time period 6A the voltage U_{pha,U} for the first phase is equal to U_{DC}/3, the voltage transmitted on the second phase is -2/3*U_{DC}, and the voltage of the third phase equals U_{DC}/3, with U_{DC} being the input direct current voltage of the three-phase inverter. During a second time period 6B occurring from π/3 to 2π/3, first switch of the third period is opened and the second switch of this third phase is closed. The voltage for the first phase is now 2/3*UDC, and the inverter is in a +-- state. For a third time period 6C occurring from 2π/3 to π, the top switch of the second phase of the inverter is closed and its bottom switch is opened, so that the inverter is in a ++- state. For a fourth time period 6D occurring from π to 4π/3, the first switch of the first phase of the inverter is closed and its second switch is opened, resulting in the inverter being in a -+- state. For a fifth time period 6E occurring from 4π/3 to 5π/3, the top switch of the third phase of the inverter is closed and the bottom switch is opened to obtain a -++ state of the inverter, and finally for a sixth time period 6F occurring from 5π/3 to 2π, the top switch of the second phase is opened and the bottom switch is opened so that the inverter is in a --+ state. During this six-step operation, while operating one half-bridge of the inverter at a time, after six full time periods 6 an AC voltage at the fundamental frequency f₀ is obtained.

The inventors have noted that during a sampling of the signal to control the inverter as part of a six-step operation, voltage harmonics appear, with a significant harmonic content of 6n-1 and 6n+1, with n being an integer. As an example, a 5^{th} harmonic and a 7^{th} harmonic appear as a 6^{th} harmonic in rotating coordinates, while a 11^{th} harmonic and a 13^{th} harmonic appear as a 12^{th} harmonic in rotating coordinates.

The AC acquisition method solves this unwanted harmonic problem with a sampling step 8 in which a plurality of AC values of the inverter are sampled from each time period 6 of the fundamental period 4. In other words, there is a plurality of sampled values S for each time period 6. The AC values are more precisely sampled from a first reference frame of the inverter, and these AC values are sampled at equidistant intervals within a given time period 6.

The sampling step 8 is carried out using any current sensing method. As examples, the sampled values S can be extracted using single-shot methods, 2-phase current sensor methods or 3-phase current sensor methods.

In the embodiment illustrated on Figure 3, which is a first embodiment, the plurality of AC values which are sampled within a given time period 6 corresponds to two values. As such, there are two sampled values S1, S2 for the first time period 6A, two sampled values S3, S4 for the second time period 6B, two sampled values S5, S6 for the third time period 6C, two sampled values for the fourth time period 6D, two sampled values for the fifth time period 6E, and two sampled values for the sixth time period 6E. Only the sampled values for the first time period 6A to the third time period 6C are represented on Figure 3, but it is understood that the sampling occurs accordingly in the fourth, fifth and sixth time periods 6D, 6E, 6F. As the sampled values S are taken at equidistant intervals, each value is here sampled at a π/6 interval.

In this first embodiment, one of the two sampled values S is sampled at the time at which a switching action of the inverter occurs, i.e. at the end of a given time period 6. As such, the second sampled values S2, S4 and S6 for each time period 6 are extracted when the inverter goes from being "on" to being "off" or conversely from being "off" to being "on". On the contrary, the first sampled values S1, S3, S5 for each time period 6 are extracted in the absence of a switching action, more precisely in the middle of a given time period 6.

The number of sampled values S per time period 6 of the fundamental period 4 depends on the embodiment. For instance, in a second embodiment of the invention which is not illustrated here, the plurality of AC values which are sampled within a given time period 6 corresponds to four values. As a result, there are four sampled values for the first time period 6A, four sampled values for the second time period 6B, four sampled values S5, S for the third time period 6C, four sampled values for the fourth time period 6D, four sampled values for the fifth time period 6E, and four sampled values for the sixth time period 6E. In this second embodiment, each value is sampled at a π/12 interval.

Other embodiments can be created by selecting any integer number of equidistant samples per time period 6 which is superior to 2 (3, 4, 5, 6...).

Once the sampling step 8 has been carried out, with at least two values having been extracted for each time period 6 of the fundamental period, the AC acquisition method 1 comprises a rotating step 10. This rotating step 10 consists in a change of reference frame. As such, the first reference frame in which the sampled values S were extracted is transformed into a second reference frame. The reference frame change is the result of a rotation. In the present embodiment, a Park transformation is used to rotate each sampled value S from the first reference frame to the second reference frame.

In the rotating step 10, the Park transformation used to rotate the sampled values S from the first reference frame to the second reference frame is function of an angle of the electric machine. The angle of the electric machine, or transformation angle, rotates with the fundamental angular frequency. It is for instance aligned with a flux of a rotor of the electric machine. The angle of the electric machine is detected by any angle sensing technology.

Once the rotating step 10 has been completed, the AC acquisition method 1 continues with an averaging step 12. Such averaging step 12 corresponds to the application of an average filter to the sampled values S in the second reference frame. In other words, the sampled values are averaged after they have undergone the Park transformation. The sampled values are more precisely averaged within each time period 6 separately. For instance, in the first embodiment of Figure 1 the average filter is applied to the two sampled values S1, S2 of the first time period 6A, then the average filter is applied to the two sampled values S3, S4 of the second time period 6B, and so on until the sixth time period 6E of the fundamental period 4.

Since the samples are done at an equidistant time over the same sampling period, the resulting values are in positive/negative opposition, so that the unwanted harmonics cancel each other out and the average filtering leads to a deletion of unwanted harmonics.

A higher number of sampled values S per time period 6 leads to a higher number of unwanted harmonics being suppressed. Thus, the number of suppressed unwanted harmonics is higher in the second embodiment compared to in the first embodiment.

As mentioned before, during the six-step operation step 2, 6n-1 harmonics and 6n+1 harmonics appear as 6n harmonics. As such, the 5^{th} harmonic and the 7^{th} harmonic appear as the 6^{th} harmonic, while the 11^{th} harmonic and the 13^{th} harmonic appear as the 12^{th} harmonic, etc. In the first embodiment, the averaging step 12 applied to the two sampled values S extracted from each time period 6 during the sampling step 8 results in the disappearance of the 6^{th} harmonic, a 18^{th} harmonic, a 30^{th} harmonic and other higher harmonics. When four values are sampled for a given time period 6, as is the case in the second embodiment, the 6^{th} harmonic, the 12^{th} harmonic, the 18^{th} harmonic and other higher harmonics are suppressed. More generally, when a number of M values is sampled for a sampling frequency of 6*M*f₀, with f₀ being the fundamental frequency, the [6*(M-1)*n+6*M*n]*f₀ harmonics disappear, while the [6*M+6*M*n] harmonics are still taken into account, with n being a positive integer ranging from 0 to infinity.

The AC acquisition method 1 ends with a final estimation step 14, during which a current value is estimated according to the previously averaged sampled values S.

The present invention thus covers an alternating current acquisition method in which a number of sample values is increased in order to average them, eliminating noise in the form of unwanted harmonics in the signal by doing so and thus providing a more accurate acquisition.

Many modifications and other embodiments of the invention set forth herein will come to mind to one skilled in the art to which the invention pertains having the benefit of the teachings presented in the foregoing descriptions and the associated drawings. Therefore, it is to be understood that the invention is not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. A method of alternating current (AC) acquisition (1) for an electric or hybrid vehicle electric machine, the method comprising:
- a step (2) in which an inverter for the electric machine is operated according to a six-step operation, during which at least one fundamental period (4) of 2π is used, the fundamental period (4) being divided into six equal time periods (6, 6A, 6B, 6C, 6D, 6E, 6F), a maximum of one single switching action occurring during each equal time period (6, 6A, 6B, 6C, 6D, 6E, 6F);
- a step (8) in which a plurality of values (S) of an AC current of the inverter from a first reference frame are sampled for each equal time period (6, 6A, 6B, 6C, 6D, 6E, 6F);
- a step (10) in which the sampled values (S) are rotated from the first reference frame to a second reference frame;
- a step (12) in which for each equal time period (6, 6A, 6B, 6C, 6D, 6E, 6F), the values (S) of the plurality of values (S) from the second reference frame are averaged;
- a step (14) in which a current value is estimated according to the averaged sampled values (S).

2. The method of alternating current acquisition (1) according to the preceding claim, wherein the values (S) are sampled at equidistant intervals.

3. The method of alternating current acquisition (1) according to any of the preceding claims, wherein the plurality of values (S) for each equal time period (6, 6A, 6B, 6C, 6D, 6E, 6F) corresponds to two values (S1, S2, S3, S4, S5, S6).

4. The method of alternating current acquisition (1) according to the preceding claim, wherein the first value and the second value of the two values (S1, S2, S3, S4, S5, S6) are respectively sampled in a first π/6 interval of the equal time period (6, 6A, 6B, 6C, 6D, 6E, 6F) and in a second π/6 interval of the equal time period.

5. The method of alternating current acquisition (1) according to any of claims 1 and 2, wherein the plurality of values (S) for each equal time period (6, 6A, 6B, 6C, 6D, 6E, 6F) corresponds to four values.

6. The method of alternating current acquisition (1) according to the preceding claim, wherein the first, second, third and fourth values of the four values are respectively sampled in a first π/12 interval of the equal time period, a second π/12 of the equal time period, a third π/12 of the equal time period, and a fourth π/12 of the equal time period.

7. The method of alternating current acquisition (1) according to any of the preceding claims, wherein one value of the plurality of values (S) is sampled at the time at which the switching action occurs.

8. The method of alternating current acquisition (1) according to any of the preceding claims, wherein the rotation of the sampled values (S) from the first reference frame to the second reference frame depends on an angle of the electric machine.

9. The method of alternating current acquisition (1) according to any of the preceding claims, wherein a Park transformation is used to rotate the sampled values (S) from the first reference frame to the second reference frame.

10. The method of alternating current acquisition (1) according to any of the preceding claims, wherein the sampling within the first reference frame is carried out using a sensing method.

## Patentansprüche

1. Ein Verfahren zur Wechselstrom (AC)-Erfassung (1) für eine elektrische Maschine eines Elektro- oder Hybridfahrzeugs, wobei das Verfahren umfasst:
- einen Schritt (2), in dem ein Wechselrichter für die elektrische Maschine gemäß einem Sechs-Stufen-Betrieb betrieben wird, während dessen mindestens eine Grundperiode (4) von 2π verwendet wird, wobei die Grundperiode (4) in sechs gleiche Zeitabschnitte (6, 6A, 6B, 6C, 6D, 6E, 6F) unterteilt ist, wobei während jedes gleichen Zeitabschnitts (6, 6A, 6B, 6C, 6D, 6E, 6F) maximal ein einziger Schaltvorgang auftritt;
- einen Schritt (8), in dem eine Vielzahl von Werten (S) eines Wechselstroms des Wechselrichters aus einem ersten Referenzrahmen für jeden gleichen Zeitabschnitt (6, 6A, 6B, 6C, 6D, 6E, 6F) abgetastet wird;
einen Schritt (10), in dem die abgetasteten Werte (S) vom ersten Referenzrahmen in einen zweiten Referenzrahmen rotiert werden;
einen Schritt (12), in dem für jeden gleichen Zeitabschnitt (6, 6A, 6B, 6C, 6D, 6E, 6F) die Werte (S) der Vielzahl von Werten (S) aus dem zweiten Referenzrahmen gemittelt werden;
- einen Schritt (14), in dem ein Stromwert gemäß den gemittelten abgetasteten Werten (S) geschätzt wird.

2. Das Verfahren zur Wechselstromerfassung (1) gemäß dem vorhergehenden Anspruch, wobei die Werte (S) in äquidistanten Intervallen abgetastet werden.

3. Das Verfahren zur Wechselstromerfassung (1) gemäß einem der vorhergehenden Ansprüche, wobei die Vielzahl von Werten (S) für jeden gleichen Zeitabschnitt (6, 6A, 6B, 6C, 6D, 6E, 6F) zwei Werten (S1, S2, S3, S4, S5, S6) entspricht.

4. Das Verfahren zur Wechselstromerfassung (1) gemäß dem vorhergehenden Anspruch, wobei der erste Wert und der zweite Wert der zwei Werte (S1, S2, S3, S4, S5, S6) jeweils in einem ersten π/6-Intervall des gleichen Zeitabschnitts (6, 6A, 6B, 6C, 6D, 6E, 6F) und in einem zweiten π/6-Intervall des gleichen Zeitabschnitts abgetastet werden.

5. Das Verfahren zur Wechselstromerfassung (1) gemäß einem der Ansprüche 1 und 2, wobei die Vielzahl von Werten (S) für jeden gleichen Zeitabschnitt (6, 6A, 6B, 6C, 6D, 6E, 6F) vier Werten entspricht.

6. Das Verfahren zur Wechselstromerfassung (1) gemäß dem vorhergehenden Anspruch, wobei der erste, zweite, dritte und vierte Wert der vier Werte jeweils in einem ersten π/12-Intervall des gleichen Zeitabschnitts, einem zweiten π/12 des gleichen Zeitabschnitts, einem dritten π/12 des gleichen Zeitabschnitts und einem vierten π/12 des gleichen Zeitabschnitts abgetastet werden.

7. Das Verfahren zur Wechselstromerfassung (1) gemäß einem der vorhergehenden Ansprüche, wobei ein Wert der Vielzahl von Werten (S) zu dem Zeitpunkt abgetastet wird, zu dem der Schaltvorgang stattfindet.

8. Das Verfahren zur Wechselstromerfassung (1) gemäß einem der vorhergehenden Ansprüche, wobei die Rotation der abgetasteten Werte (S) vom ersten Referenzrahmen in den zweiten Referenzrahmen von einem Winkel der elektrischen Maschine abhängt.

9. Das Verfahren zur Wechselstromerfassung (1) gemäß einem der vorhergehenden Ansprüche, wobei eine Park-Transformation verwendet wird, um die abgetasteten Werte (S) vom ersten Referenzrahmen in den zweiten Referenzrahmen zu rotieren.

10. Das Verfahren zur Wechselstromerfassung (1) gemäß einem der vorhergehenden Ansprüche, wobei die Abtastung innerhalb des ersten Referenzrahmens mittels eines Erfassungsverfahrens durchgeführt wird.

## Revendications

1. Un procédé d'acquisition de courant alternatif (AC) (1) pour une machine électrique de véhicule électrique ou hybride, le procédé comprenant :
- une étape (2) dans laquelle un onduleur pour la machine électrique est exploité selon un fonctionnement en six étapes, durant lequel au moins une période fondamentale (4) de 2π est utilisée, la période fondamentale (4) étant divisée en six périodes de temps égales (6, 6A, 6B, 6C, 6D, 6E, 6F), un maximum d'une seule action de commutation se produisant durant chaque période de temps égale (6, 6A, 6B, 6C, 6D, 6E, 6F) ;
- une étape (8) dans laquelle une pluralité de valeurs (S) d'un courant alternatif de l'onduleur depuis un premier référentiel sont échantillonnées pour chaque période de temps égale (6, 6A, 6B, 6C, 6D, 6E, 6F) ;
- une étape (10) dans laquelle les valeurs échantillonnées (S) sont pivotées du premier référentiel vers un second référentiel ;
- une étape (12) dans laquelle, pour chaque période de temps égale (6, 6A, 6B, 6C, 6D, 6E, 6F), les valeurs (S) de la pluralité de valeurs (S) du second référentiel sont moyennées ;
- une étape (14) dans laquelle une valeur de courant est estimée selon les valeurs échantillonnées moyennées (S).

2. Le procédé d'acquisition de courant alternatif (1) selon la revendication précédente, dans lequel les valeurs (S) sont échantillonnées à des intervalles équidistants.

3. Le procédé d'acquisition de courant alternatif (1) selon l'une quelconque des revendications précédentes, dans lequel la pluralité de valeurs (S) pour chaque période de temps égale (6, 6A, 6B, 6C, 6D, 6E, 6F) correspond à deux valeurs (S1, S2, S3, S4, S5, S6).

4. Le procédé d'acquisition de courant alternatif (1) selon la revendication précédente, dans lequel la première valeur et la seconde valeur des deux valeurs (S1, S2, S3, S4, S5, S6) sont respectivement échantillonnées dans un premier intervalle de π/6 de la période de temps égale (6, 6A, 6B, 6C, 6D, 6E, 6F) et dans un second intervalle de π/6 de la période de temps égale.

5. Le procédé d'acquisition de courant alternatif (1) selon l'une quelconque des revendications 1 et 2, dans lequel la pluralité de valeurs (S) pour chaque période de temps égale (6, 6A, 6B, 6C, 6D, 6E, 6F) correspond à quatre valeurs.

6. Le procédé d'acquisition de courant alternatif (1) selon la revendication précédente, dans lequel les première, deuxième, troisième et quatrième valeurs des quatre valeurs sont respectivement échantillonnées dans un premier intervalle de π/12 de la période de temps égale, un deuxième π/12 de la période de temps égale, un troisième de π/12 de la période de temps égale, et un quatrième π/12 de la période de temps égale.

7. Le procédé d'acquisition de courant alternatif (1) selon l'une quelconque des revendications précédentes, dans lequel une valeur de la pluralité de valeurs (S) est échantillonnée au moment où l'action de commutation se produit.

8. Le procédé d'acquisition de courant alternatif (1) selon l'une quelconque des revendications précédentes, dans lequel la rotation des valeurs échantillonnées (S) du premier référentiel vers le second référentiel dépend d'un angle de la machine électrique.

9. Le procédé d'acquisition de courant alternatif (1) selon l'une quelconque des revendications précédentes, dans lequel une transformation de Park est utilisée pour faire pivoter les valeurs échantillonnées (S) du premier référentiel vers le second référentiel.

10. Le procédé d'acquisition de courant alternatif (1) selon l'une quelconque des revendications précédentes, dans lequel l'échantillonnage dans le premier référentiel est effectué à l'aide d'une méthode de détection.
